# EUROPÄISCHE PATENTANMELDUNG

(11) **EP 1 184 866 A2**
(43) Veröffentlichungstag der Anmeldung: **06.03.2002**
(21) Anmeldenummer: 01118995.8
(22) Anmeldetag: 06.08.2001
(51) Int. Cl.: G11C 7/06

(54) **Elektronische Verstärkerschaltung mit schaltbarem Eingangstransistor**

(30) Priorität: 25.08.2000 DE 10041796
(71) Anmelder: Infineon Technologies AG, 81669 München (DE)
(72) Erfinder: Paul, Steffen, 82065 Baierbrunn (DE); Wicht, Bernhard, 80798 München (DE)
(74) Vertreter: Graf Lambsdorff, Matthias, Dr.

(57) **Zusammenfassung**

Eine elektronische Verstärkerschaltung nach dem Prinzip der Stromdetektion ist mit einem Speicherzellenfeld gekoppelt und weist jeweils einen Eingangstransistor für jede Zeile oder Spalte der matrixförmigen Anordnung auf, welcher mit der jeweiligen Zeile oder Spalte verbunden ist und durch ein Steuersignal (SEL) einer Multiplexerschaltung (2) ansteuerbar und schaltbar ist. Die Verstärkerschaltung kann als Gateschaltung oder als Transistordiodenschaltung ausgebildet sein.

## Beschreibung

Die Erfindung betrifft eine elektronische, stromsensitive Verstärkerschaltung für die Verstärkung von elektrischem Strom, welcher aus einer Zeile oder einer Spalte einer matrixförmigen Anordnung von elektronischen oder optoelektronischen Bauelementen geliefert wird. Die matrixförmige Anordnung wird dabei insbesondere durch ein Zellenfeld aus Speicherzellen, insbesondere statischen SRAM-Speicherzellen gebildet. Sie kann jedoch ebenso durch ein Zellenfeld von Photodetektoren, insbesondere Photodioden definiert sein. Die Erfindung bezieht sich weiterhin auf eine ebensolche matrixförmige Anordnung von Speicherzellen, insbesondere statischen SRAM-Speicherzellen oder Photodetektoren, insbesondere Photodioden, wobei die matrixförmige Anordnung mit einer erfindungsgemäßen Verstärkerschaltung verbunden ist, die ihrerseits mit einer die Verstärkerschaltung ansteuernden Multiplexerschaltung gekoppelt ist.

Elektronische Verstärkerschaltungen zum Auslesen von Speicherzellenfeldern, sogenannte Ausleseverstärker, nach dem Prinzip der Stromdetektion weisen gegenüber der Spannungsdetektion eine geringere Ausleseverzögerung auf, weil der Strom der Speicherzelle niederohmig ausgekoppelt wird, wie insbesondere in den Publikationen "Current-Mode Techniques for High-Speed VLSI Circuits with Application to Current Sense Amplifier for CMOS SRAM's" von Seevinck et al. in IEEE Journal of Solid-State Circuits, Vol. 26, No. 4, Seiten 525-536 (nachfolgend "Seevinck" genannt) und "Current Sense Amplifiers for Low-Voltage Memories" von N. Shibata in IEICE Trans. Electron., Vol. E79-C, No. 8, Seiten 1120-1130 (nachfolgend "Shibata I" genannt) beschrieben worden ist. Je kleiner der Eingangswiderstand des Ausleseverstärkers ist, desto geringer wird die benötigte Zeit zum Auslesen des Speicherinhaltes.

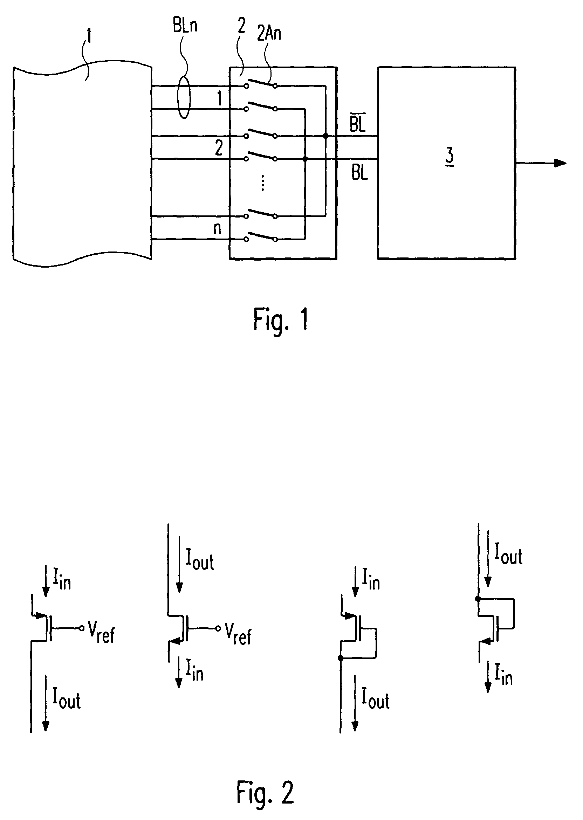

Die Erfindung bezieht sich insbesondere auf Speicherarchitekturen, bei denen jedem Ausleseverstärker mehrere Spalten (Bit-Leitungspaare) zugeordnet werden, von denen jeweils eine durch eine Multiplexerschaltung an den Ausleseverstärker geschaltet wird. Eine derartige Anordnung ist in der Fig. 1 dargestellt. In dieser Anordnung soll der Speicherinhalt von Speicherzellen eines SRAM-Speicherzellenfeldes 1 ausgelesen werden. Die Speicherzellen in dem Speicherzellenfeld 1 sind entlang von n Bitleitungen matrixförmig aufgereiht. Das Speicherzellenfeld 1 weist n Bit-Leitungspaare BLn auf, die über entsprechende Ausgänge des Speicherzellenfeldes 1 mit einer Multiplexerschaltung 2 verbunden sind. Diese Multiplexerschaltung 2 weist im wesentlichen einen zweipoligen Ausgang und n Schalter, insbesondere MOS-Transistoren 2An auf, deren Aufgabe es ist, durch Vorgabe der Multiplexerschaltung 2 eines der Bit-Leitungspaare BLn mit dem Ausgang zu verbinden. Der Ausgang der Multiplexerschaltung 2 ist mit einem Ausleseverstärker 3 gekoppelt, durch den das von dem entsprechenden Bit-Leitungspaar gelieferte Stromsignal verstärkt und an seinem Ausgang einer Informationsausgabe zugeführt wird.

Der von der Multiplexerschaltung 2 jeweils ausgewählte und eingeschaltete MOS-Transistor 2An weist jedoch einen endlichen Widerstand auf, der in Reihe zu dem Eingangswiderstand des Ausleseverstärkers 3 liegt und damit einen nachteiligen Einfluß auf das Zeitverhalten und die Höhe des in den Ausleseverstärker 3 fließenden Signalstroms hat. Dies ist in der Publikation "Megabit-Class Size-Configurable 250-MHz SRAM Macrocells with a Squashed-Memory-Cell Architecture" von N. Shibata et al. in IEICE Trans. Electron., Vol. E82 C, No. 1, Seiten 94-103 (nachfolgend "Shibata II" genannt) untersucht worden.

Im Stand der Technik werden derartige Nachteile zumeist in Kauf genommen, wie die Publikation "A 7-ns 140-mW 1-Mb CMOS SRAM with Current Sense Amplifier" von K. Sasaki et al. in IEEE Journal of Solid-State Circuits, Vol. 27, No. 11, Seiten 1511-1518 (nachfolgend "Sasaki" genannt) zeigt.

Alternativ werden Ausleseverstärker mit dem klassischen Prinzip der Spannungsdetektion zum Auslesen statischer Speicherzellen eingesetzt ("Seevinck", Fig. 10). Hierbei wird die Bit-Leitungsspannung hochohmig abgegriffen. Da praktisch kein Strom über den Multiplexertransistor fließt, ist sein Widerstand in Bezug auf das Zeitverhalten unkritisch. Die Spannungsdetektion ist jedoch prinzipiell langsamer als die Stromdetektion, da die hohe Bit-Leitungskapazität umgeladen werden muß.

Als weitere Alternative zur Lösung der oben genannten Probleme werden Ausleseverstärker mit so geringer Fläche eingesetzt, daß sie genau einem Bit-Leitungspaar zugeordnet werden können ("Seevinck"). Damit entfällt der Multiplexer an der für die Auslesezeit kritischen Stelle zwischen Bit-Leitung und Ausleseverstärker. Jedoch führt die erhöhte Anzahl von Ausleseverstärkern zu einem erhöhten Flächenbedarf.

Es ist demnach Aufgabe der vorliegenden Erfindung, eine elektronische, stromsensitive Verstärkerschaltung mit verbesserten Eigenschaften, insbesondere verbessertem Zeitverhalten für die Verstärkung von Strom aus einer matrixförmigen Anordnung von elektronischen oder optoelektronischen Bauelementen anzugeben.

Diese Aufgabe wird durch die Merkmale des Patentanspruchs 1 gelöst. Vorteilhafte Weiterbildungen sind in den Unteransprüchen angegeben.

Ein wesentlicher Gedanke der vorliegenden Erfindung liegt darin, daß eine elektronische, stromsensitive Vestärkerschaltung für die Verstärkung von elektrischem Strom ausgelegt ist, der aus einer Zeile oder einer Spalte einer matrixförmigen Anordnung von elektronischen oder optoelektronischen Baulementen geliefert wird, jeweils einen Eingangstransistor für jede Zeile oder Spalte der matrixförmigen Anordnung aufweist, welcher mit der betreffenden Zeile oder Spalte verbunden ist, und durch ein Steuersignal einer Multiplexerschaltung ansteuerbar und schaltbar ist.

Der Eingangstransistor der Verstärkerschaltung wird somit gleichzeitig als Schalttransistor der Multiplexerschaltung genutzt. Statt von einer festen Spannung wird der Gateanschluß des Eingangstransistors von dem Multiplexersignal angesteuert, wodurch der Transistor ein- und ausgeschaltet werden kann und somit selbst funktionell Teil der Multiplexerschaltung wird. Im eingeschalteten Zustand (Gateanschluß je nach Transistortyp mit der Betriebsspannung bzw. mit Masse verbunden) wirkt der Transistor als Verstärker nach dem Prinzip der Gateschaltung (Kaskode) und stellt den geforderten niedrigen Eingangswiderstand her. Ausleseverstärker nach diesem Prinzip realisieren die einfachste Form der Stromdetektion, weisen allerdings gegenüber aufwendigeren Schaltungen ("Shibata I", Table 1) einen verhältnismäßig hohen Eingangswiderstand auf. Durch die vorgeschlagene Verknüpfung mit der Multiplexerfunktion ergibt sich jedoch gegenüber anderen Lösungen ein Flächenvorteil. Damit ist die erfindungsgemäße Lösung vorrangig geeignet für Produkte mit strengen Beschränkungen im Flächenbedarf und mittleren Anforderungen bei der Auslesegeschwindigkeit. Da keine zusätzlichen Verstärker benötigt werden, fällt auch der Leistungsverbrauch nicht sehr hoch aus. Aufgrund ihrer Einfachheit weisen die erfindungsgemäßen Schaltungen auch eine hohe Zuverlässigkeit auf.

Die Erfindung ist insbesondere für ein Speicherzellenfeld, insbesondere ein Zellenfeld aus statischen SRAM-Speicherzellen geeignet. Die erfindungsgemäße Verstärkerschaltung kann jedoch auch mit einer Matrix von Photodetektoren, insbesondere Photodioden, gekoppelt werden, deren Pixel ebenfalls über einen Multiplexer an einen Ausleseverstärker geschaltet werden können. Auch hier kommen die Vorteile der erfindungsgemäßen Verstärkerschaltung zum Tragen.

Im folgenden werden Ausführungsbeispiele der erfindungsgemäßen Schaltung anhand der Zeichnungen näher erläutert. Es zeigen:
- Fig. 1: eine konventionelle Schaltung aus einem SRAM-Speicherzellenfeld, einer Multiplexerschaltung und einem Ausleseverstärker,
- Fig. 2: einfache Prinzipschaltungen von Ausleseverstärkern für Stromdetektion,
- Fig. 3A, B: eine Gegenüberstellung der konventionellen Lösung und des Erfindungsprinzips (A) und ein Ausführungsbeispiel einer erfindungsgemäßen Verstärkerschaltung (B) .

In der Fig. 2 sind einfache, an sich im Stand der Technik bekannte Schaltungsvarianten für einen Ausleseverstärker nach dem Prinzip der Stromdetektion dargestellt. In den Schaltbildern sind die Transistoren als MOS-Transistoren abgebildet. Dies stellt keine prinzipielle Einschränkung dar; anstelle von MOS-Transistoren ist auch der Einsatz von Bipolartransistoren denkbar.

In den beiden linken Teilbildern sind stromsensitive Ausleseverstärker auf der Basis der Gateschaltung dargestellt, wobei das äußere Teilbild eine Gateschaltung mit einem p-Kanal-Transistor und das innere Teilbild eine Gateschaltung mit einem n-Kanal-Transistor zeigt. In den beiden rechten Teilbildern wird ein Transistor dadurch zu einer Transistordiode umfunktioniert, daß das Gate mit Source bzw. Drain verbunden wird. Im rechten Teilbild ist ein n-Kanal-Transistor dargestellt, während im inneren Teilbild ein p-Kanal-Transistor gezeigt ist.

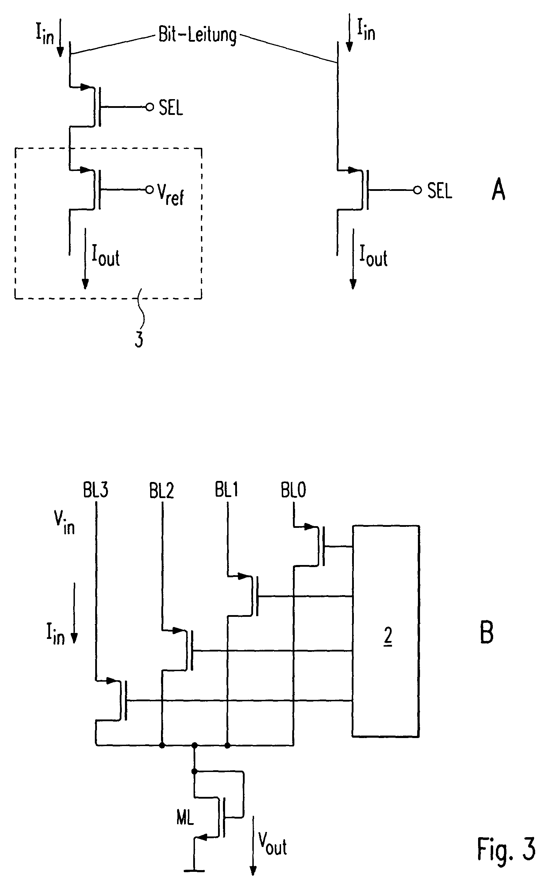

In der eingangs erwähnten Publikation "Shibata I" ist ebenfalls in der Fig. 3 eine Gateschaltung dargestellt. Der zu messende Strom aus dem Speicherzellenfeld fließt über den Transistor der Gateschaltung zu einem Lastwiderstand, über dem eine Spannung abfällt, die ein Maß für den zu messenden Strom ist. Die in der Fig. 3 dieser Publikation dargestellte Gateschaltung und der zugehörige Beschreibungstext wird hiermit durch Inbezugnahme in den Offenbarungsgehalt der vorliegenden Anmeldung aufgenommen.

In der Fig. 3A der vorliegenden Anmeldung ist im linken Teilbild in vereinfachter Darstellung nochmals eine konventionelle Ausleseverstärker-Multiplexer-Kombination gezeigt, bei der an den Gateanschluß des Eingangstransistors des Ausleseverstärkers 3 eine konstante Spannung V_{ref} angelegt wird. Zur Auswahl einer bestimmten Bit-Leitung wird der dieser Bit-Leitung zugehörige Transistor von einem Multiplexersignal SEL angesteuert. Bei der im rechten Teilbild dargestellten erfindungsgemäßen Lösung wird dagegen ein einziger Transistor verwendet, der gleichzeitig Eingangstransistor des Ausleseverstärkers und Schalttransistor des Multiplexers ist. Der Gateanschluß dieses einzigen Transistors wird von dem Multiplexersignal SEL angesteuert, wodurch der Transistor ein- und ausgeschaltet werden kann. Im eingeschalteten Zustand ist der Gateanschluß je nach Transistortyp mit der Betriebsspannung oder mit Masse verbunden. In diesem Zustand wirkt der Transistor als Verstärker nach dem Prinzip der Gateschaltung und stellt den geforderten niedrigen Eingangswiderstand her.

In der Fig. 3B ist ein Ausführungsbeispiel der erfindungsgemäßen Verstärkerschaltung dargestellt. Diese ist mit einer Anzahl von Bit-Leitungen BL0, BL1, BL2 und BL3 gekoppelt, welche mit den entsprechenden Ausgängen eines Speicherzellenfeldes verbunden sind. Um eine der Bit-Leitungen BL0 bis BL3 auszuwählen, wird der entsprechende Transistor beispielsweise dadurch eingeschaltet, daß sein Gateanschluß von einer Multiplexerschaltung 2 an Masse gelegt wird. Während der von der Speicherzelle gelieferte Strom Iᵢₙ zum Lasttransistor ML fließt, entsteht nur ein geringer Spannungshub an der jeweiligen Bit-Leitung. An dem Lasttransistor ML kann eine dem Eingangsstrom entsprechende Spannung Vₒᵤₜ zur Weiterverarbeitung abgegriffen werden. Es sind somit sämtliche Eingangstransistoren ausgangsseitig miteinander und mit dem Lasttransistor ML verbunden. Der Lasttransistor ML ist als Transistordiode ausgebildet, indem sein Gateanschluß mit Drain verbunden ist.

Alternativ hierzu kann auch die Gateschaltung der Fig. 3 der Publikation "Shibata I" analog verwendet werden, indem die Eingangstransistoren ausgangsseitig miteinander und mit einem Lastwiderstand verbunden werden, an dem ein Spannungsabfall als Maß des zu messenden Stroms abgegriffen wird.

## Patentansprüche

1. Elektronische, stromsensitive Verstärkerschaltung für die Verstärkung von elektrischem Strom, welcher aus einer Zeile oder einer Spalte einer matrixförmigen Anordnung (1) von elektronischen oder optoelektronischen Bauelementen geliefert wird, mit
- jeweils einem Eingangstransistor für jede Zeile oder Spalte der matrixförmigen Anordnung (1), welcher mit der entsprechenden Zeile oder Spalte verbunden ist und
- durch ein Steuersignal (SEL) einer Multiplexerschaltung (2) ansteuerbar und schaltbar ist.

2. Verstärkerschaltung nach Anspruch 1,
**dadurch gekennzeichnet, daß**
- die Eingangstransistoren ausgangsseitig miteinander und mit einem Lasttransistor (ML) verbunden sind, dessen Gate bzw. Basis mit Source oder Drain bzw. Emitter oder Collector verbunden ist.

3. Verstärkerschaltung nach Anspruch 1,
**dadurch gekennzeichnet, daß**
- die Eingangstransistoren ausgangsseitig miteinander und mit einem Lastwiderstand verbunden sind.

4. Verstärkerschaltung nach einem der vorhergehenden Ansprüche,
**dadurch gekennzeichnet, daß**
- die matrixförmige Anordnung (1) ein Zellenfeld aus Speicherzellen, insbesondere statischen SRAM-Speicherzellen ist.

5. Verstärkerschaltung nach einem der Ansprüche 1 bis 3,
**dadurch gekennzeichnet, daß**
- die matrixförmige Anordnung ein Zellenfeld von Photodetektoren, insbesondere Photodioden ist.

6. Matrixförmige Anordnung von Speicherzellen, insbesondere statischen SRAM-Speicherzellen, welche mit einer Verstärkerschaltung nach einem der vorhergehenden Ansprüche verbunden ist, welche ihrerseits mit einer Multiplexerschaltung (2) zur Ansteuerung und Einschaltung ihrer Eingangstransistoren gekoppelt ist.

7. Matrixförmige Anordnung von Photodetektoren, insbesondere Photodioden, welche mit einer Verstärkerschaltung nach einem der vorhergehenden Ansprüche verbunden ist, welche ihrerseits mit einer Multiplexerschaltung (2) zur Ansteuerung und Einschaltung ihrer Eingangstransistoren gekoppelt ist.
